# EUROPÄISCHE PATENTANMELDUNG

(11) **EP 2 151 869 A2**
(43) Veröffentlichungstag der Anmeldung: **10.02.2010**
(21) Anmeldenummer: 09008349.4
(22) Anmeldetag: 26.06.2009
(51) Int. Cl.: H01L 31/0224, H01L 31/06

(54) **Halbleiter-Bauelement**

(30) Priorität: 08.08.2008 DE 102008037033; 16.12.2008 DE 102008062591
(71) Anmelder: Deutsche Cell Gmbh, 09587 Freiberg/Sachsen (DE)
(72) Erfinder: Krause, Andreas, 01187 Dresden (DE); Bitnar, Bernd, Dr., 09599 Freiberg (DE); Neuhaus, Holger, Dr., 09599 Freiberg (DE); Kutzer, Martin, 09322 Penig (DE); Schlegel, Kristian, 08056 Zwickau (DE); Lengsfeld, Claudia, 09599 Freiberg (DE)
(74) Vertreter: Rau, Albrecht

(57) **Zusammenfassung**

Ein Halbleiter-Bauelement (1), insbesondere in Form einer Solarzelle, umfasst ein flächig ausgebildetes Halbleiter-Substrat (2) mit einer ersten Seite (3), einer dieser gegenüberliegenden zweiten Seite (4), einer senkrecht auf diesen stehenden Flächennormalen (5), und einer Vielzahl zumindest auf der zweiten Seite (4) angeordneten, sich in Richtung der Flächennormalen (5) erstreckenden Vertiefungen (9), mindestens eine auf der zweiten Seite (4) angeordnete, dielektrische Passivierungs-Schicht (6), eine auf der Passivierungs-Schicht (6) angeordnete, elektrisch leitende Kontakt-Schicht (8), eine Vielzahl von Kontakt-Elementen (12) zur elektrischen Verbindung der Kontakt-Schicht (8) mit dem Halbleiter-Substrat (2), welche elektrisch leitfähig sind, sowohl mit dem Halbleiter-Substrat (2) als auch mit der Kontakt-Schicht (8) in elektrisch leitender Verbindung stehen, jeweils eine der Vertiefungen (9) zu mindestens 50%, insbesondere mindestens 90%, vorzugsweise vollständig ausfüllen, in Richtung senkrecht zur Flächennormalen (5) mit einem Überstand (13) über die Vertiefungen (9) überstehen und aus einem gut lötbaren Material sind.

## Beschreibung

Die Erfindung betrifft ein Halbleiter-Bauelement sowie ein Verfahren zur Herstellung eines Halbleiter-Bauelements.

Bei lasergefeuerten (LFC-)Solarzellen ist auf der sonnenabgewandten Rückseite der Solarzelle üblicherweise eine Metallschicht aus Aluminium aufgebracht. Es ist bekannt, dass das Verlöten von Aluminium technisch sehr aufwändig ist. Auch eine galvanische Abscheidung einer gut lötbaren Metallschicht auf der Aluminiumschicht ist nicht ohne weiteres möglich, da die Aluminiumschicht spontan eine nicht-elektronenleitende Aluminiumoxid-Oberflächen-Schicht ausbildet. Eine galvanische Beschichtung der Rückseite einer LFC-Solarzelle ist somit nicht ohne spezielle Vorbehandlung möglich. Derartige Vorbehandlungen sind aufwändig und teuer. Außerdem führten sie zu einer verminderten Haftfestigkeit der abgeschiedenen Schichten.

Der Erfindung liegt daher die Aufgabe zugrunde, ein Halbleiter-Bauelement mit einer verbesserten Kontakt-Schicht zu schaffen. Der Erfindung liegt weiterhin die Aufgabe zugrunde, ein Verfahren zur Herstellung eines derartigen Halbleiter-Bauelements bereitzustellen.

Diese Aufgabe wird erfindungsgemäß durch die Merkmale der Ansprüche 1 und 12 gelöst. Der Kern der Erfindung besteht darin, die mittels eines Lasers erzeugten Vertiefungen an der Oberfläche eines Halbleiter-Substrats mittels galvanischer Abscheidung von Kontakten aufzufüllen. Vorteilhafterweise sind die Vertiefungen in zumindest einem Teilbereich auf der Oberfläche des Halbleiter-Substrats derart angeordnet, dass benachbarte Kontakte miteinander verschmelzen und eine zusammenhängende Kontakt-Struktur bilden. Weitere Vorteile ergeben sich aus den Unteransprüchen.

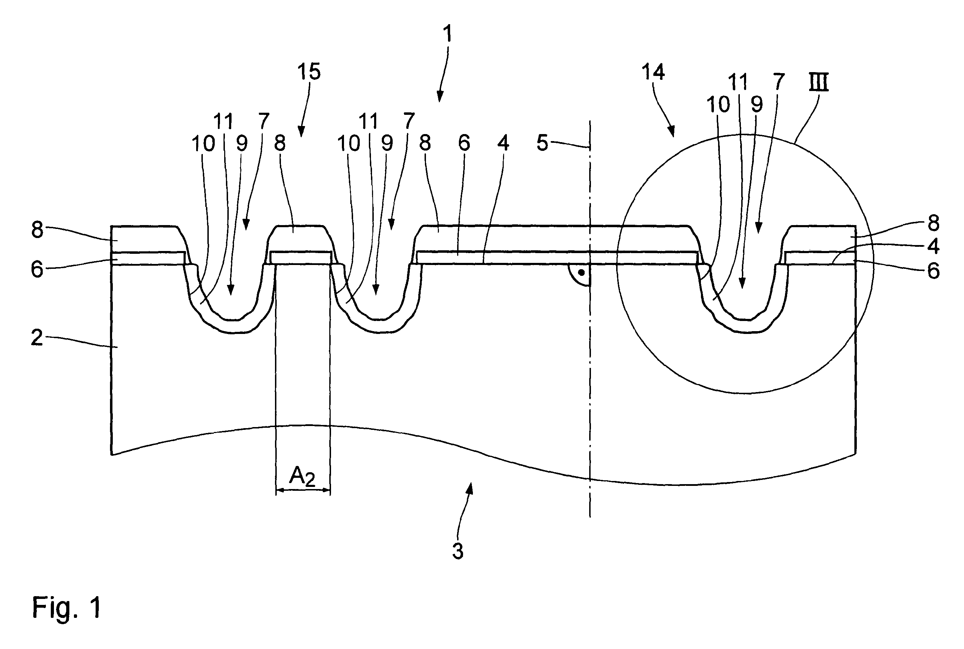

Merkmale und Einzelheiten der Erfindung ergeben sich aus der Beschreibung mehrerer Ausführungsbeispiele anhand der Zeichnungen. Es zeigen
- Fig. 1: einen Querschnitt durch ein Halbleiter-Bauelement gemäß ei- nem Ausführungsbeispiel vor Auffüllung der LFC-Kontakte,

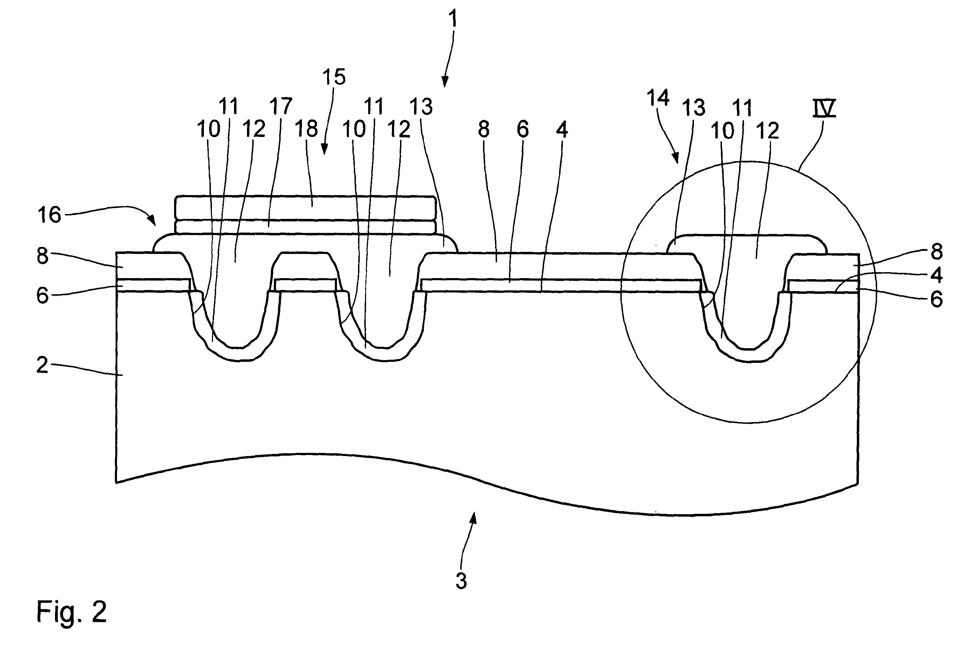

- Fig. 2: einen Querschnitt durch das Halbleiter-Bauelement gemäß Fig. 1 nach der Verlötung der Kontakte,

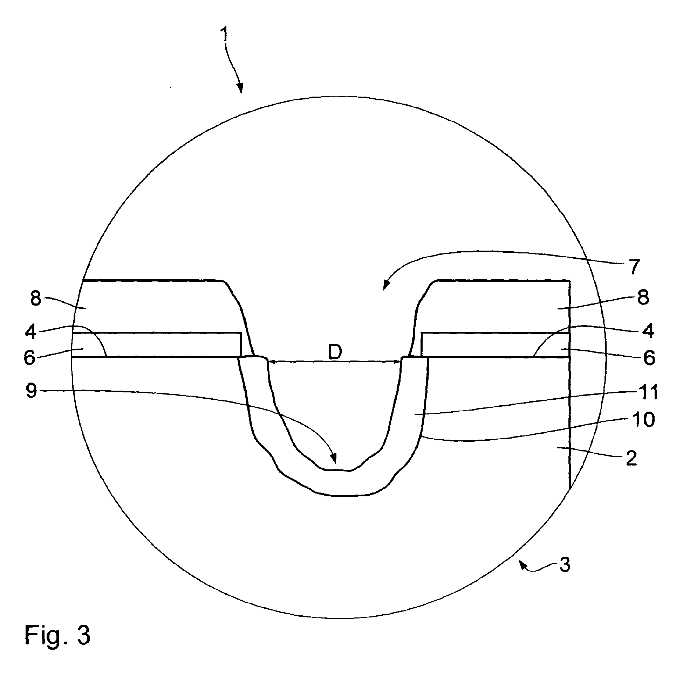

- Fig. 3: eine Ausschnittsvergrößerung des Bereichs III aus Fig. 1,

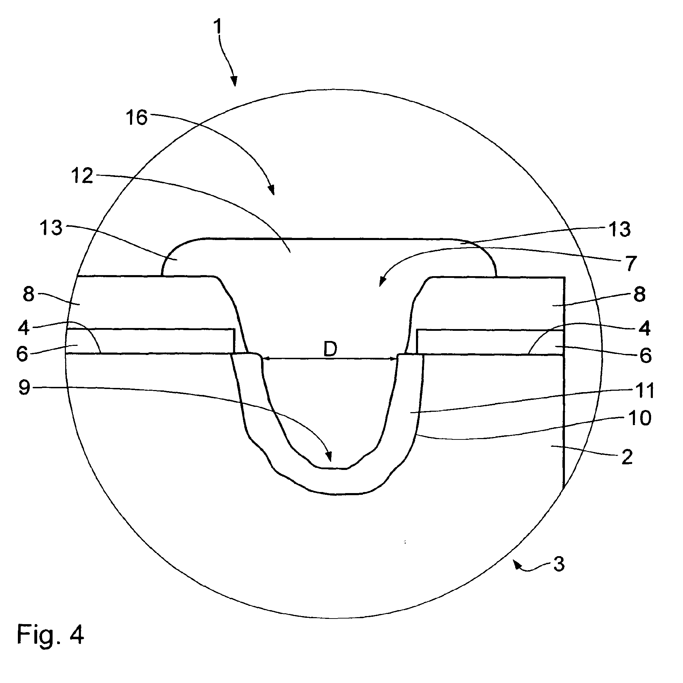

- Fig. 4: eine Ausschnittsvergrößerung des Bereichs IV aus Fig. 2,

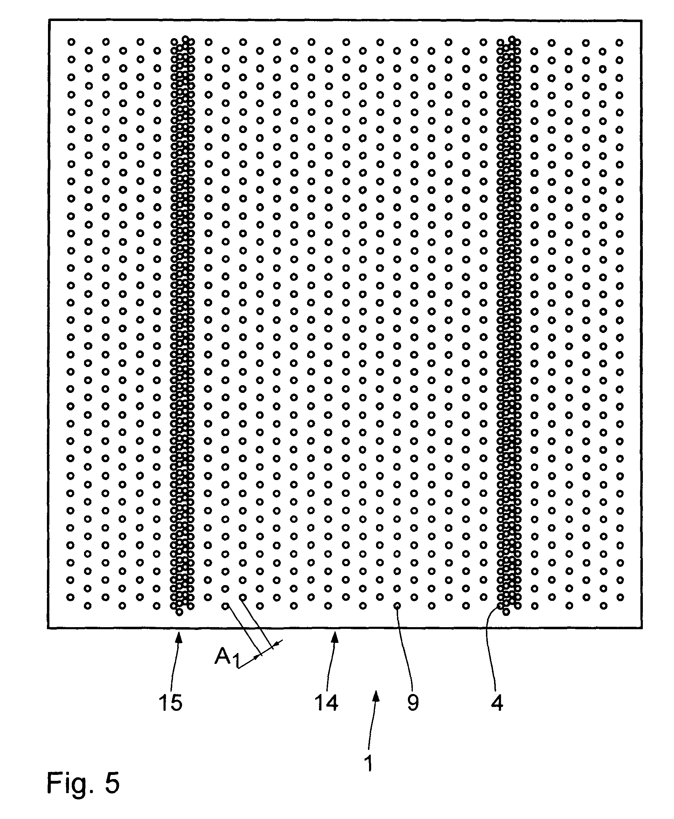

- Fig. 5: eine Ansicht der Rückseite des Halbleiter-Bauelements gemäß Fig. 1,
- Fig. 6: eine Ansicht der Rückseite des Halbleiter-Bauelements gemäß einem weiteren Ausführungsbeispiel und
- Fig. 7: eine vereinfachte Schnitt-Darstellung entlang der Linie VII - VII des Ausführungsbeispiels gemäß Fig. 6.

Ein insbesondere als Solarzelle ausgebildetes Halbleiter-Bauelement 1 umfasst ein flächig ausgebildetes Halbleiter-Substrat 2 mit einer Vorderseite 3, einer dieser gegenüberliegenden Rückseite 4 und einer senkrecht auf er Vorderseite 3 und der Rückseite 4 stehenden Flächennormalen 5. Das Halbleitersubstrat 2 ist aus einem Halbleiter-Material, insbesondere aus Silizium. Andere Halbleiter-Materialien sind jedoch ebenfalls denkbar. Auf der Rückseite 4 des Halbleiter-Substrats 2 ist eine elektrische Passivierungs-Schicht 6 aufgebracht, die auch als interner Licht-Reflektor ausgelegt sein kann. Die Passivierungs-Schicht 6 ist elektrisch isolierend. Sie ist vorzugsweise aus Siliziumnitrid oder Siliziumdioxid. Die Passivierungsschicht 6 weist eine Vielzahl von Öffnungen 7 auf. Die Öffnungen 7 haben Abmessungen senkrecht zur Flächennormalen 5, welche im Verhältnis zu den Abmessungen des Halbleiter-Substrats 2 sehr klein sind. Sie werden daher auch als punktförmig bezeichnet. Die Öffnungen 7 sind insbesondere kreisförmig. Die Öffnungen werden durch Laserpulse hergestellt.

Außerdem umfasst das Halbleiter-Bauelement 1 eine auf der Passivierungsschicht 6 angeordnete, elektrisch leitende Kontakt-Schicht 8. Die Kontakt-Schicht 8 ist aus einem gut elektrisch leitfähigen Metall, insbesondere aus Aluminium. Sie ist auf ihrer dem Halbleiter-Substrat 2 zugewandten Seite reflektierend ausgebildet.

Die Öffnungen 7 durchdringen die Kontakt-Schicht 8 und die darunter liegende Passivierungsschicht 6 in Richtung der Flächennormalen 5 vollständig. Im Bereich dieser Öffnungen 7 weist das Halbleiter-Substrat 2 Vertiefungen 9 auf, welche sich in Richtung der Flächennormalen 5 erstrecken.

Die Vertiefungen 9 haben senkrecht zur Flächennormalen 5 einen runden, insbesondere einen kreisförmigen Querschnitt. Sie haben einen Durchmesser D senkrecht zur Flächennormalen im Bereich von 1 µm bis 100 µm, insbesondere im Bereich von 25 µm bis 75 µm.

Die Vertiefungen 9 weisen jeweils eine dem Halbleiter-Substrat zugewandte Boden-Wand 10 auf. Auf dieser ist eine Boden-Schicht 11 ausgebildet, welche zumindest einen Anteil des Materials der Kontakt-Schicht 8 und einen Anteil des Materials des Halbleiter-Substrats 2 aufweist. Die Boden-Schicht 11 kann zusätzlich insbesondere Dotierstoffe aufweisen. Die Boden-Schicht 11 steht in elektrischem Kontakt mit der Kontakt-Schicht 8. Die Boden-Schicht 11 ist insbesondere als eine mit Aluminium hochdotierte Silizium-Schicht ausgebildet. Die Boden-Schicht 11 weist vorteilhafterweise eine Aluminium-Metall- und/oder eine Silizium-Metall-Legierung auf. Sie ist daher gut leitfähig. Die Boden-Schicht 11 weist insbesondere auch einen Anteil an Bor auf.

Des Weiteren umfasst das Halbleiter-Bauelement 1 eine Vielzahl von Kontakt-Elementen 12 zur elektrischen Verbindung der Kontakt-Schicht 8 mit dem Halbleiter-Substrat 2. Die Kontakt-Elemente 12 sind elektrisch gut leitfähig. Sie sind außerdem gut lötbar. Die Kontakt-Elemente 12 weisen einen Anteil an Nickel auf. Der Nickelanteil beträgt mindestens 50 %, insbesondere mindestens 90 %, insbesondere mindestens 99 %. Vorzugsweise weisen die Kontakt-Elemente 12 außerdem einen Anteil an Bor auf. Anstelle des Bor-Anteils kann auch ein anderer Dotierstoff vorgesehen sein. Im Kontaktbereich zwischen dem Kontakt-Element 12 und der Boden-Schicht 11 in der Vertiefung 9 im Halbleiter-Substrat 2 ist eine Nickel-Silizium-Legierung, insbesondere Nickelsilizid ausgebildet. Entsprechend ist im Kontaktbereich zwischen dem Kontakt-Element 12 und der Kontakt-Schicht 8 eine Aluminium-Nickel-Legierung ausgebildet. Hierdurch ist der Kontaktwiderstand zwischen dem Halbleiter-Substrat 2 und der Kontakt-Struktur 16 einerseits beziehungsweise zwischen der Kontakt-Struktur 16 und der Kontakt-Schicht 8 andererseits erheblich reduziert.

Die Kontakt-Elemente 12 stehen somit sowohl mit dem Halbleiter-Substrat 2 als auch mit der Kontakt-Schicht 8 in elektrisch leitender Verbindung. Sie füllen die Vertiefungen 9 jeweils zu mindestens 50 %, insbesondere mindestens 90 %, vorzugsweise vollständig aus. In Richtung senkrecht zur Flächennormalen 5 stehen die Kontakt-Elemente 12 mit einem Überstand 13 jeweils über die Vertiefungen 9 über. Der Überstand 13 liegt hierbei auf der Kontakt-Schicht 8 auf.

Die Vertiefungen 9 mit den Kontakt-Elementen 12 sind in einem regelmäßigen Muster auf der Rückseite 4 des Halbleiter-Substrats 2 angeordnet. Hierbei weist das Muster mindestens zwei Teilbereiche 14, 15 auf. Der zweite Teilbereich 15 ist streifenförmig ausgebildet. Er umfasst mindestens einen, vorzugsweise mehrere, parallel zueinander verlaufende, linienförmige Unterbereiche. Benachbarte Vertiefungen 9 im ersten Teilbereich 14 haben einen ersten Abstand A₁, während benachbarte Vertiefungen 9 im zweiten Teilbereich 15 einen zweiten Abstand A₂ haben. Der zweite Abstand A₂ ist kleiner als der erste Abstand A₁, A₂ < A₁. Der zweite Abstand A₂ liegt im Bereich von 10 µm bis 200 µm, insbesondere im Bereich von 50 µm bis 120 µm, insbesondere im Bereich von 80 µm bis 100 µm. Der zweite Abstand A₂ ist insbesondere weniger als zweimal so groß wie der Überstand 13 der Kontakt-Elemente 12 über die Vertiefungen 9 in Richtung senkrecht zur Flächennormalen 5, sodass sich benachbarte Kontakt-Elemente 12 im zweiten Teilbereich 15 mittels ihrer Überstände 13 berühren und somit eine zusammenhängende Kontakt-Struktur 16 bilden. Der Überstand 13 ist jedoch kleiner, als dass die Kontakt-Struktur 16 das Halbleiter-Substrat 2 vollständig, das heißt lückenlos überdeckte. Mit anderen Worten bleiben auch im zweiten Teilbereich 15 Zwischenräume zwischen den sich berührenden Kontakt-Elementen 12, welche Poren in der zusammenhängenden Kontakt-Struktur 16 bilden. Die Kontakt-Struktur 16 wird daher auch als offenporig bezeichnet. Durch diese Poren sind die mechanischen Eigenschaften der Kontakt-Struktur 16 wesentlich verbessert. Insbesondere können durch die Poren thermische Spannungen zwischen der Kontakt-Struktur 16 und dem Halbleiter-Substrat 2 ausgeglichen werden. Die Kontakt-Struktur 16 ist linienförmig ausgebildet. Sie wird auch als Busbar bezeichnet.

Im Gegensatz zum zweiten Teilbereich 15 ist der Abstand A₁ zwischen zwei benachbarten Kontakt-Elementen 12 im ersten Teilbereich 14 mehr als zweimal so groß wie der Überstand 13 der Kontakt-Elemente 12 über die Vertiefungen 9 in Richtung senkrecht zur Flächennormalen 5. Im ersten Teilbereich 14 sind die einzelnen Kontakt-Elemente 12 somit voneinander elektrisch isoliert. Der erste Abstand A₁ liegt im Bereich von 200 µm bis 20.000 µm. Er beträgt vorzugsweise mindestens 500 µm, insbesondere mindestens 1.000 µm.

Die Vertiefungen 9 mit den Kontakt-Elementen 12 sind vorzugsweise an den Ecken eines regulären, insbesondere eines quadratischen, rechteckigen oder hexagonalen Gitters angeordnet.

Im zweiten Teilbereich 15 ist die Kontakt-Struktur 16, das heißt die Kontakt-Elemente 12 mittels einer Lot-Schicht 17 mit Kontakt-Bändchen 18 verlötet. Die Lot-Schicht 17 kann aus einem Zinn-Blei-Lot oder aus einem bleifreien Zinn-Lot sein. Vorteilhafterweise weist das Lot der Lot-Schicht 17 einen Anteil an Wismut auf. Diesbezüglich sei auf die DE 10 2008 031 836.1 verwiesen.

Es ist vorgesehen, dass das Halbleiter-Bauelement 1 zu jeweils einer der Kontakt-Strukturen 16 eine entsprechend ausgebildete Kontakt-Struktur auf der Vorderseite 3 aufweist, wobei die Kontakt-Strukturen 16 auf der Vorder- und Rückseite 3, 4 jeweils in Richtung der Flächennormalen 5 fluchtend zueinander angeordnet sind.

In einer alternativen Ausführungsform wird auf den zweiten Teilbereich mit einer enger benachbarten Anordnung der Vertiefungen 9 mit den Kontakt-Elementen 12 verzichtet. Stattdessen ist vorgesehen, auf der Rückseite 4 des Halbleiter-Bauelements 1 ganzflächig eine Folie aus einem gut leitfähigen und weich lötbarem Material, beispielsweise aus Kupfer oder einer Metalllegierung wie Messing, anzubringen, wobei die Folie mit den Kontakt-Elementen 12 verlötet ist. Vorteilhafterweise ist die Metallfolie mit einem Zinn-Lot beschichtet. Auf diese Folie können sodann wiederum die Kontakt-Bändchen 18 zum Verbinden mehrerer Halbleiter-Bauelemente 1 in einem Modul aufgelötet werden. Durch die Metallfolie wird die Querleitfähigkeit der Rückseite 4 der LFC-Solarzelle deutlich verbessert, wodurch der Widerstandsverlust reduziert und ein Wirkungsgradgewinn generiert werden kann. Auf die Verlötung mit Kontakt-Bändchen kann verzichtet werden, wenn eine geeignet geformte Folie auf den frontseitigen Busbar der benachbarten Solarzelle geführt wird, wodurch die Folie die Serienverschaltung der einzelnen Solarzellen herstellt.

Im Folgenden wird ein Verfahren zur Herstellung des Halbleiter-Bauelements 1 beschrieben. Zunächst wird das Halbleiter-Bauelement 1 mit lasergefeuerten (LF-)Kontakten bereitgestellt. Für die Herstellung des Halbleiter-Bauelements 1 mit LF-Kontakten sei auf die DE 10 2008 024 053.2 verwiesen. Als Ausgangspunkt dient das Halbleiter-Substrat 2, insbesondere ein Siliziumwafer, welcher zumindest auf seiner Rückseite 4, vorzugsweise auch auf seiner Vorderseite 3 mit der Passivierungs-Schicht 6 und der auf dieser angeordneten Kontakt-Schicht 8 versehen wird. Sodann wird das Halbleiter-Substrat 2 mittels eines gepulsten Lasers mit den Vertiefungen 9 versehen. Beim Einbringen der Vertiefungen in das Halbleiter-Substrat 2 bilden sich die Öffnungen 7 in der Kontakt-Schicht 8 und der darunter liegenden Passivierungsschicht 6 aus. Vorteilhafterweise ist zum Einbringen der Vertiefungen 9 ein flüssigkeitsstrahl-geführter Laser vorgesehen. Hierbei kann der Flüssigkeitsstrahl vorzugsweise Dotierstoffe wie Phosphor, Arsen, Antimon oder auch Bor, Indium, Aluminium, Gallium oder deren Verbindungen enthalten.

Zum Auffüllen der Vertiefungen 9 werden die Kontakt-Elemente 12 aus einem dotierstoff-haltigen Elektrolyten in die Vertiefungen 9 abgeschieden. Hierbei erfolgt die Abscheidung ausschließlich in den Vertiefungen 9. Auf der Kontakt-Schicht 8 findet aufgrund einer sich spontan ausbildenden, nicht-elektronenleitenden Aluminiumoxid-Schicht keine galvanische Metallabscheidung statt. Die galvanische Abscheidung der Kontakt-Elemente 12 wird solange fortgesetzt, bis die Vertiefungen 9 vollständig aufgefüllt sind, und die Kontakt-Elemente 12 in Richtung senkrecht zur Flächennormalen 5 über die Vertiefungen 9 überstehen. Aufgrund der speziellen Anordnung der Vertiefungen 9 auf der Rückseite 4 des Halbleiter-Substrats 2 wachsen die Überstände 13 der Kontakt-Elemente 12 im zweiten Teilbereich 15 hierbei zusammen und bilden somit die zusammenhängende, teilweise geschlossene, offenporige Kontakt-Struktur 16. Durch das Auffüllen der Vertiefungen 9 werden außerdem mögliche Unterbrechungen des Kontakts zwischen dem Halbleiter-Substrat 2 und der Kontakt-Schicht 8 im Bereich der Öffnungen 7 überbrückt, wodurch der Leistungsverlust am Kontaktwiderstand der lasergefeuerten Kontakte reduziert wird.

Da die Kontakt-Elemente 12 gut mit Lot benetzbar sind, lässt sich die Kontakt-Struktur 16 sehr gut mit Kontakt-Bändchen 18 verlöten. Die Kontakt-Bändchen 18 gehen hierbei eine haftfeste Verbindung mit dem Halbleiter-Bauelement 1 ein. Thermische Spannungen, welche aufgrund von unterschiedlichen Ausdehnungskoeffizienten des Halbleiter-Substrats 2 und der Kontakt-Struktur 16 beim Verlöten derselben typischerweise auftreten können, werden zumindest teilweise durch die Poren zwischen den Kontakt-Elementen 12 ausgeglichen.

In einem weiteren Ausführungsbeispiel ist vorgesehen, das Halbleiter-Bauelement 1 nach der Abscheidung der Kontakt-Elemente 12 in den Vertiefungen 9 zu tempern. Die Temperatur liegt bei diesem Temperschritt im Bereich zwischen 300 °C und 700 °C, insbesondere im Bereich zwischen 400 °C und 550 °C. Beim Tempern des Halbleiter-Bauelements 1 bildet sich in den Vertiefungen 9, insbesondere im Bereich der Boden-Schicht 11 Nickelsilizid. Entsprechend bildet sich im Kontakt-Bereich zwischen den Überständen 13 der Kontakt-Elemente 12 und der Kontakt-Schicht 8 eine Aluminium-Nickel-Legierung. Hierdurch wird der Kontaktwiderstand zwischen den Kontakt-Elementen 12 und dem Halbleiter-Substrat 2 einerseits und den Kontakt-Elementen 12 und der Kontakt-Schicht 8 andererseits erheblich reduziert. Außerdem bilden sich beim Tempern in der Boden-Schicht 11 Aluminium-Silizium-Legierungen. Schließlich begünstigt das Tempern die Diffusion von Dotierstoff, der optional in die Kontakt-Elemente 12 eingelagert ist, durch die Boden-Wand 10 in das Halbleiter-Substrat 2.

Das Tempern wird vorzugsweise in einer Inertgas-Atmosphäre durchgeführt. Wird alternativ hierzu an Luft getempert, ist zur Wiederherstellung der Lötbarkeit der Kontakt-Elemente 12 eine Behandlung deren Oberfläche in Salzsäure vorgesehen. Die Salzsäure hat vorzugsweise eine Konzentration von ungefähr 20 %.

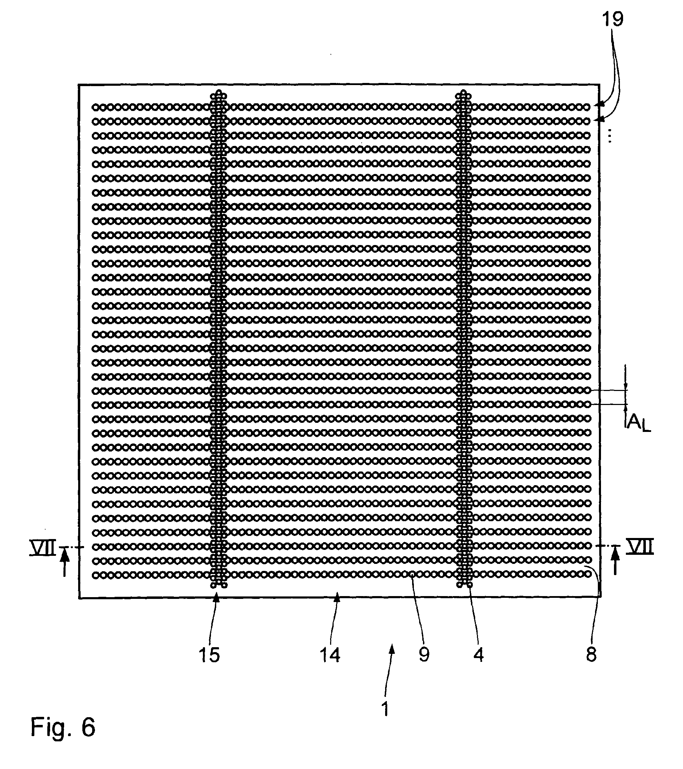

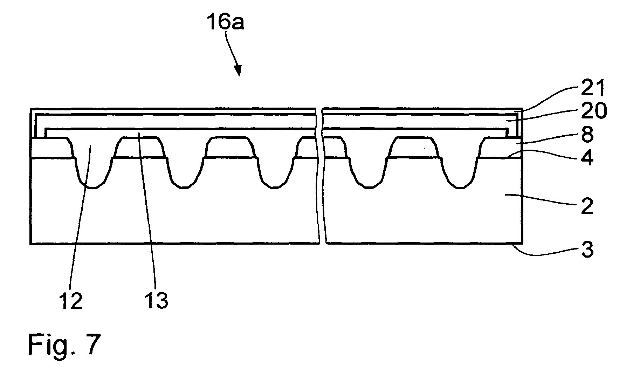

Im Folgenden wird unter Bezugnahme auf die Figuren 6 und 7 ein weiteres Ausführungsbeispiel der Erfindung beschrieben. Identische Teile erhalten dieselben Bezugszeichen wie beim ersten Ausführungsbeispiel, auf dessen Beschreibung hiermit verwiesen wird. Konstruktiv unterschiedliche jedoch funktionell gleichartige Teile erhalten dieselben Bezugszeichen mit einem nachgestellten a. Bei diesem Ausführungsbeispiel sind die Kontakt-Elemente 12 im ersten Teilbereich 14 in Linien angeordnet. Die Linien verlaufen vorzugsweise senkrecht zur Ausrichtung der linienförmig ausgebildeten, Busbare bildenden Kontakt-Struktur 16a im zweiten Teilbereich 15.

Somit umfasst die Kontakt-Struktur 16a bei diesem Ausführungsbeispiel zusätzlich zu den Busbaren im zweiten Teilbereich 15 linienförmig ausgebildete Quer-Kontakte 19. Die Quer-Kontakte 19 sind senkrecht zu den Busbaren angeordnet. Die Quer-Kontakte 19 sind elektrisch leitend mit den Busbaren verbunden. Sie verbinden die Busbare miteinander. Sie sind insbesondere so angeordnet, dass sie Kontaktfingern auf der Vorderseite 3 des Halbleiter-Substrats 2 in Richtung der Flächennormalen 5 gegenüber liegen. Sie sind vorzugsweise mit einem Linienabstand A_{L} angeordnet, welcher dem Abstand A₁ des ersten Ausführungsbeispiels entspricht. Der Linienabstand A_{L} ist vorzugsweise ein ganzzahliges Vielfaches, insbesondere zweifaches oder dreifaches, des Abstandes der Kontaktfinger auf der Vorderseite 3. Durch die Anordnung der linienförmigen Quer-Kontakte 19 gegenüber den Kontaktfingern auf der Vorderseite 3 des Halbleiter-Substrats 2 werden Rekombinationsverluste möglichst gering gehalten.

Durch die Quer-Kontakte 19 wird die Querleitfähigkeit der Rückseite 4 bereitgestellt. Hierdurch ist es möglich, die Dicke der Kontakt-Schicht 8 zu reduzieren. Dies führt zu einer verkürzten Prozesszeit, Material- und Kosteneinsparungen. Die Kontakt-Schicht 8 weist bei diesem Ausführungsbeispiel eine Dicke D_{K} auf, welche höchstens 0,5 µm, insbesondere höchstens 0,2 µm, insbesondere höchstens 0,1 µm beträgt.

Die Kontakt-Elemente 12 sind entsprechend wie beim ersten Ausführungsbeispiel ausgebildet. Zur Verbesserung ihrer Leitfähigkeit ist zusätzlich eine auf ihnen abgeschiedene Leit-Schicht 20 vorgesehen. Die Lein-Schicht 20 weist eine Dicke im Bereich von 3 µm bis 50 µm auf. Die Dicke der Kontakt-Elemente 12, gemessen von der Rückseite 4 des Halbleiter-Substrats 2 in Richtung der Flächennormalen 5, liegt im Bereich von 1 µm bis 5 µm. Die Leit-Schicht 20 umfasst vorzugsweise einen Anteil an Kupfer. Sie besteht insbesondere vollständig aus Kupfer oder einer Kupferverbindung. Die Kontakt-Elemente 12 bilden hierbei eine Sperr-Schicht, welche eine Diffusion von Kupferionen in das Halbleiter-Substrat 2 verhindert.

Auf der Leit-Schicht 20 ist eine Löt-Schicht 21 vorgesehen. Die Löt-Schicht 21 weist eine Dicke im Bereich von 1 µm bis 5 µm auf. Sie weist zumindest einen Anteil Nickel, Silber, Zinn oder einer Verbindung dieser Metalle auf. Sie besteht vorzugsweise aus Silber, Nickel oder Zinn.

Die Kontakt-Struktur 16a umfasst somit die Kontakt-Schicht 8, die Sperr-Schicht, die Leit-Schicht 20 und die Löt-Schicht 21. Eine entsprechende Ausbildung der Kontakt-Struktur 16a ist selbstverständlich auch beim ersten Ausführungsbeispiel möglich.

Die beschriebenen Kontakt-Strukturen 16, 16a können ebenso zur Erzeugung einer Vorderseitenmetallisierung mit hohem Aspektverhältnis angewendet werden. In diesem Fall wird die Kontakt-Schicht 8 im Bereich zwischen den Kontakt-Strukturen 16, 16a nach Abscheidung derselben wieder entfernt. Dies geschieht beispielsweise mittels geeigneter Chemikalien, insbesondere einer Natriumhydroxidlösung.

## Patentansprüche

1. Halbleiter-Bauelement (1), insbesondere in Form einer Solarzelle, umfassend
a. ein flächig ausgebildetes Halbleiter-Substrat (2) mit
i. einer ersten Seite (3),
ii. einer dieser gegenüberliegenden zweiten Seite (4),
iii. einer senkrecht auf diesen stehenden Flächennormalen (5), und
iv. einer Vielzahl zumindest auf der zweiten Seite (4) angeordneten, sich in Richtung der Flächennormalen (5) erstreckenden Vertiefungen (9),
b. mindestens eine auf der zweiten Seite (4) angeordnete, dielektrische Passivierungs-Schicht (6),
c. eine auf der Passivierungs-Schicht (6) angeordnete, elektrisch leitende Kontakt-Schicht (8),
d. eine Vielzahl von Kontakt-Elementen (12) zur elektrischen Verbindung der Kontakt-Schicht (8) mit dem Halbleiter-Substrat (2), welche
i. elektrisch leitfähig sind,
ii. sowohl mit dem Halbleiter-Substrat (2) als auch mit der Kontakt-Schicht (8) in elektrisch leitender Verbindung stehen,
iii. jeweils eine der Vertiefungen (9) zu mindestens 50%, insbesondere mindestens 90%, vorzugsweise vollständig ausfüllen,
iv. in Richtung senkrecht zur Flächennormalen (5) mit einem Überstand (13) über die Vertiefungen (9) überstehen und
v. aus einem gut lötbaren Material sind.

2. Halbleiter-Bauelement (1) gemäß Anspruch 1, **dadurch gekennzeichnet, dass** die Vertiefungen (9) einen Durchmesser D senkrecht zur Flächennormalen im Bereich von 1 µm bis 100 µm, insbesondere im Bereich von 25 µm bis 75 µm aufweisen.

3. Halbleiter-Bauelement (1) gemäß einem der vorhergehenden Ansprüche**, dadurch gekennzeichnet, dass** die Kontakt-Schicht (8) aus Aluminium ist.

4. Halbleiter-Bauelement (1) gemäß einem der vorhergehenden Ansprüche, **dadurch gekennzeichnet, dass** die Vertiefungen (9) in einem regelmäßigen Muster auf der zweiten Seite (4) des Halbleiter-Substrats (2) angeordnet sind, wobei das Muster mindestens zwei Teilbereiche (14, 15) umfasst, und benachbarte Vertiefungen (9) im ersten Teilbereich (14) einen ersten Abstand A₁ haben, während benachbarte Vertiefungen (9) im zweiten Teilbereich (15) in mindestens einer Richtung einen zweiten Abstand A₂ < A₁ haben.

5. Halbleiter-Bauelement (1) gemäß Anspruch 4, **dadurch gekennzeichnet, dass** die Vertiefungen in zumindest einem der Teilbereiche (14, 15) an den Eckpunkten eines regulären, insbesondere eines hexagonalen Gitters angeordnet sind.

6. Halbleiter-Bauelement (1) gemäß Anspruch 4 oder 5, **dadurch gekennzeichnet, dass** der erste Abstand A₁ mehr als zweimal so groß ist wie der Überstand (13) der Kontakt-Elemente (12) über die Vertiefungen (9) in Richtung senkrecht zur Flächennormalen (5).

7. Halbleiter-Bauelement (1) gemäß einem der Ansprüche 4 bis 6, **dadurch gekennzeichnet, dass** der zweite Abstand A₂ weniger als zweimal so groß ist wie der Überstand (13) der Kontakt-Elemente (12) über die Vertiefungen (9) in Richtung senkrecht zur Flächennormalen (5), so dass sich benachbarte Kontakt-Elemente (12) mittels ihrer Überstände (13) berühren und somit eine zusammenhängende zweite Kontakt-Struktur (16; 16a) bilden.

8. Halbleiter-Bauelement (1) gemäß Anspruch 7, **dadurch gekennzeichnet, dass** die Kontakt-Struktur (16; 16a) mindestens einen linienförmigen Busbar umfasst.

9. Halbleiter-Bauelement (1) gemäß Anspruch 8, **dadurch gekennzeichnet, dass** die Kontakt-Struktur (16a) linienförmige Quer-Kontakte (19) umfasst, welche insbesondere senkrecht zu dem mindestens einen, linienförmigen Busbar angeordnet sind.

10. Halbleiter-Bauelement (1) gemäß einem der Ansprüche 4 bis 9, **dadurch gekennzeichnet, dass** der zweite Abstand A₂ im Bereich von 10 µm bis 200 µm, insbesondere im Bereich von 50 µm bis 120 µm, vorzugsweise im Bereich von 80 µm bis 100 µm liegt.

11. Halbleiter-Bauelement (1) gemäß Anspruch 8, **dadurch gekennzeichnet, dass** zu jeweils einer linienförmigen Kontakt-Struktur (16) eine entsprechend ausgebildete Kontakt-Struktur (16) auf der ersten Seite (3) vorgesehen ist, wobei die Kontakt-Strukturen (16) in Richtung der Flächennormalen (5) fluchtend zueinander angeordnet sind.

12. Verfahren zur Herstellung eines Halbleiter-Bauelements (1) umfassend die folgenden Schritte:
- Bereitstellen eines flächigen Halbleiter-Substrats (2) mit
- - einer ersten Seite (3),
- - einer zweiten Seite (4),
- - einer senkrecht auf diesen stehenden Flächennormalen (5),
- - mindestens einer auf der zweiten Seite (4) angeordneten, elektrisch isolierenden, ersten Passivierungs-Schicht (6) und
- - mindestens einer auf der Passivierungs-Schicht (6) angeordneten Kontakt-Schicht (8),
- Einbringen von durch die erste Passivierungs-Schicht (6) in das Halbleiter-Substrat (2) hineinreichenden Vertiefungen (9) mittels eines Lasers,
- Auffüllen der Vertiefungen (9) mittels galvanischer Abscheidung von Kontakt-Elementen (12).

13. Verfahren gemäß Anspruch 12, **dadurch gekennzeichnet, dass** die galvanische Abscheidung der Kontakt-Elemente (12) ausschließlich im Bereich der Vertiefungen (9) stattfindet.

14. Verfahren gemäß einem der Ansprüche 12 oder 13, **dadurch gekennzeichnet, dass** die galvanische Abscheidung solange fortgesetzt wird, bis ein Teil der Kontakt-Elemente (12) so weit in Richtung senkrecht zur Flächennormalen (5) über die Vertiefungen (9) übersteht, dass sich benachbarte Kontakt-Elemente (12) berühren.

15. Verfahren gemäß einem der Ansprüche 12 bis 14, **dadurch gekennzeichnet, dass** die Kontakt-Elemente (12) mit Kontakt-Bändchen (18) verlötet werden.
